# EUROPÄISCHE PATENTSCHRIFT

(11) **EP 1 700 243 B1**
(45) Veröffentlichungstag und Bekanntmachung des Hinweises auf die Patenterteilung: **02.10.2013**
(21) Anmeldenummer: 04790356.2
(22) Anmeldetag: 09.10.2004
(51) Int. Cl.: G06F 17/50

(54) **VERFAHREN ZUR ERMITTLUNG VON KONSTRUKTIVEN ERSTMODELLDATEN FÜR EINE TECHNISCHE LEICHTBAUSTRUKTUR**
METHOD FOR DETERMINING CONSTRUCTIONAL PROTOTYPE DATA FOR A TECHNICAL LIGHTWEIGHT STRUCTURE
PROCEDE DE DETERMINATION DE DONNEES DE CONSTRUCTION DE MODELE INITIAL POUR UNE STRUCTURE DE CONSTRUCTION LEGERE

(30) Priorität: 30.11.2003 DE 10356682
(43) Veröffentlichungstag der Anmeldung: 13.09.2006
(73) Patentinhaber: Stiftung Alfred-Wegener-Institut für Polar- und Meeresforschung, 27570 Bremerhaven (DE)
(72) Erfinder: HAMM, Christian, 27580 Bremerhaven (DE)
(86) Internationale Anmeldenummer: PCT/EP2004/011483
(87) Internationale Veröffentlichungsnummer: WO 2005/052818

(56) Entgegenhaltungen:
- RALF MESKE, JÜRGEN SAUTER, MATTHIAS FRIEDRICH: "Topologie- und Gestaltoptimierung mit CAOSS und ABAQUS"[Online] 29. November 2000 (2000-11-29), XP002328332 ABAQUS ANWENDERTREFFEN 2000, WINTERTHUR Gefunden im Internet: URL:http://www.fe-design.de/fileadmin/publ ikationen/publikationen2000/2000-09-29_ABA QUS_Anwendertreffen_Paper.pdf> [gefunden am 2005-05-17]
- HAMM C E ET AL: "Architecture and material properties of diatom shells provide effective mechanical protection" NATURE NATURE PUBLISHING GROUP UK, Bd. 421, Nr. 6925, 20. Februar 2003 (2003-02-20), Seiten 841-843, XP002328333 ISSN: 0028-0836 in der Anmeldung erwähnt
- PARKINSON J ET AL: "Beyond micromachining: the potential of diatoms" TRENDS IN BIOTECHNOLOGY, ELSEVIER, AMSTERDAM, NL, Bd. 17, Nr. 5, Mai 1999 (1999-05), Seiten 190-196, XP004181356 ISSN: 0167-7799

## Beschreibung

Die vorliegende Erfindung bezieht sich auf ein rechnergestütztes Verfahren zur Ermittlung von konstruktiven Erstmodelldaten für eine technische Leichtbaustruktur.

Die Verwendung von Vorbildern aus der Natur für technische Anwendungen ist seit Langem bekannt und dem menschlichen Verhalten nahe gelegt. Die Natur hat im Laufe der Evolution durch natürliche Auslese extrem energiesparende Konstruktionen und Verfahren als Antwort auf die Frage nach der besten Strategie im dauernden Überlebenskampf der Arten hervorgebracht, die für viele technische Anwendungen, wenn auch aus anderen Beweggründen, geeignet und wünschenswert erscheinen. Die Umsetzung scheitert dabei aber in der Regel an der Problematik, das biologische System unmittelbar auf das gewünschte technische System anwendbar zu machen. Grundlage für eine solche Umsetzung muss einerseits das exakte Studium des morphologischen Aufbaus biologischer Systeme einschließlich der verwendeten natürlichen Materialien und ihrer Eigenschaften und andererseits der Erwerb genauer Kenntnisse über deren Zweck, also den Gesamtzusammenhang des betrachteten Systems in seiner natürlichen Umgebung sein. Erst eine solchermaßen umfassende Aufklärung aus biologisch-technischer Sicht ermöglicht es dem Konstrukteur, technische Systeme unter Berücksichtigung biologischer Wirkmechanismen zu gestalten. Die Wissenschaft von der systematischen technischen Umsetzung biologischer Konstruktionen und Verfahren in die technische Welt wird allgemein als Bionik oder Biomimetik bezeichnet.

Eine Vielzahl von Veröffentlichungen befasst sich mit der Ausdeutung solcher Prinzipien und der Darstellung des jeweiligen Standes der Technik. Die **Veröffentlichung I** (Werner Nachtigall, "Vorbild Natur- Bionik-Design für funktionelles Gestalten", Springer Verlag, 1997) beschreibt die Grundprinzipien natürlicher Konstruktionen [I, S.21 ff]: Die Natur konstruiert nicht additive, auf einzelne Haupteigenschaften maximierte Komponenten, sondern entwickelt integrierte, im Hinblick auf die Summe seiner notwendigen Eigenschaften optimierte Systeme. In der Natur steht dem System der durch Nahrungsaufnahme erwerbbaren Energie der energetische Aufwand zur Verteidigung/Flucht einerseits und der Fortpflanzung andererseits gegenüber. Je effektiver Energie eingesetzt werden kann, desto größer die Überlebenschance. Leichte und dabei stabile Bauweisen und detaillierte Anpassungen an unterschiedlichste Umweltbedingen sind die Folge und stellen einen großen, für die Technik nutzbaren Designpool dar. Als bekanntes Beispiel für bionisches Design kann der Lotus-Effekt dienen [I, S.43-44]. Dabei konnte nachgewiesen werden, dass Oberflächen, z.B. von Blättern, mit einer definierten Verteilung von Mikrorauigkeiten die Anhaftung von Schmutzpartikeln und Wassertropfen sehr wirksam verhindern, indem Wassertropfen nicht flächig anheften, sondern durch ihre Oberflächenspannung auf den Spitzen der Rauigkeiten abrollen und dabei den ebenfalls nur auf den Spitzen der Rauigkeiten ruhenden Schmutz einrollen und mitnehmen. Diese Fähigkeit gestattet es den Pflanzen, sich effektiv selbst zu reinigen und dabei die zum Überleben wichtige Lichtausbeute auf hohem Niveau zu halten. Auf technischen Oberflächen kann dieser Selbstreinigungseffekt durch Beschichtung mit anderen, die Rauigkeit der Pflanzenblätter nachbildenden Materialien ebenfalls erzielt werden. Damit kann nicht nur der Reinigungsaufwand z.B. von Solarzellen zur Aufrechterhaltung der Lichtausbeute sondern auch von optischen Flächen wie Hausfassaden und Fensterscheiben deutlich reduziert werden. Es gibt eine Reihe weiterer Beispiele aus der Tierwelt, z.B. die Ausnutzung der strömungstechnischen und der Antifoulingeigenschaften von Walhaut, der richtungsabhängigen Reibungserzeugung von Schlangenhaut usw. Für die technische Umsetzung solcher Analogien wird in der Veröffentlichung [I, S.127-130] die notwendige Modellbildung in dem Schritt Prinzip-Nullmodell-Endausführung (Abb.67) jedoch nicht näher beschrieben.

In der **Veröffentlichung II** (Claus Mattheck, "Design in der Natur - Der Baum als Lehrmeister", Rombach Ökologie, 1997) [II, S.13-18, 45-47] wird der Mechanismus der biologischen Selbstoptimierung, d.h. der Optimierung des Energieeinsatzes, anhand des Beispiels des adaptiven Wachstums von Bäumen behandelt. Durch die ständigen Veränderungen der Lebensbedingungen im Laufe seines Daseins unterliegt der Baumstamm unterschiedlichen Spannungsverhältnissen durch Wind, Sonne, Bodenbeschaffenheit usw. Die genetische Disposition des Baums befähigt ihn nun, ungünstigen Spannungsverteilungen durch unterschiedliches Dickenwachstum zwischen gefährdeten und ungefährdeten Stellen entgegenzuwirken. Er verfolgt immer das Ziel, im zeitlichen Mittel auf der gesamten Oberfläche des Baumstamms konstante Spannung wirken zu lassen. Dieselben Verhältnisse gelten auch für andere, mechanisch hochbelastete Bauteile der Natur wie Knochen, Zähne, Krallen usw. Das zugrunde liegende Prinzip, das Axiom von der konstanten Spannung, kann als Grundlage für biologisch-technisches Konstruieren betrachtet werden. Auch hier zeigt sich wieder, dass das energieoptimierte Design der Natur, d.h. bei für den vorgesehenen Einsatzzweck notwendigen Krafteinleitungen durch Weglassung von spannungsfreien Zonen minimiertem Bauteilgewicht, Vorbildfunktionen für ökologisch und wirtschaftlich optimierte technische Strukturen erfüllt. Bei der Beschreibung der Vorgehensweise zur Umsetzung ökologischen Designs [II, S.63, 64], von der die Erfindung als nächstliegendem Stand der Technik ausgeht, werden die anwendbaren Methoden und deren Zusammenwirken kurz dargestellt. Die technische Aufgabenstellung liefert zunächst die relevanten Grundparameter für die herzustellende technische Struktur einer Konstruktion. Hierbei handelt es sich beispielsweise um die ungefähre Bauteildimension (Grenzabmessung), die angreifenden äußeren Belastungen und die Randbedingungen (Einspannung, Auflager, Führungen etc.). Die Mechanik liefert z.B. mit der Finite-Element-Methode (FEM) als numerischem Handwerkszeug die auftretenden Spannungen, Dehnungen und Verformungen in der technischen Struktur. Mit der so genannten Soft Kill Option (SKO) können dann nichttragende Konstruktionsbereiche als unnötiger Ballast beseitigt werden. Somit kann ein voroptimierter Leichtbaudesignvorschlag als Erstmodell zur Verfügung gestellt werden, das aber noch Problemzonen aufweist. Diese können mit der so genannten Computer Aided Optimization (CAO) durch weiteres Schrumpfen und Verändern der Konstruktion nachbehandelt werden, sodass durch einen iterativen Optimierungsprozess schließlich die zu erstellende Konstruktion mit einer dauerfesten Leichtbaustruktur entsteht. Dabei hängt der Umfang des Optimierungsprozesses direkt von der Qualität des Erstmodells ab. Je näher dieses bereits an der fertigen Endkonstruktion liegt, desto geringer ist der Optimierungsaufwand. Insgesamt sind jedoch nur relativ einfache Strukturen umsetzbar, und schon die Erstellung des datenbasierten Erstmodells nach dem Vorbild aus der Natur erfordert im Stand der Technik langwierige Übertragungs- und Rechenprozesse. Abhilfe bietet hier bislang nur die Verwendung sehr einfacher Erstmodelle, wodurch sich der Rechenaufwand aber nur auf die Optimierung an der endgültigen Konstruktion verlagert, da die Abweichung zum Erstmodell sehr groß ist.

**Die Veröffentlichung III** (Hamm, Merkel, Springer, Jurkojs, Maier, Prechtel, Smetacek, "Architecture and material properties of diatom shells provide effective mechanical protection", Nature, Vol.421, S.841-843, Feb.2003) beschäftigt sich mit dem speziellen und vielfältigen konstruktiven Aufbau von *Diatomeen* (Kieselalgen) als Schutzeinrichtung. Insbesondere im Hinblick auf mechanisch beanspruchte Leichtbaustrukturen für Konstruktionen im Maschinenbau oder mechanisch-ästethische Schöpfungen der Architektur können die Schalenkonstrukte biomineralisierte Einzelier, und hier besonders der *Bacillariophyceen* (*Diatomeen ,* Phytoplankton) und *Phaeodarien* (*Radiolarien,* Zooplankton) eine entscheidende Vorbildrolle spielen. Hier ist eine große Vielfalt von Strukturen gegeben, deren Hauptaufgabe im Schutz gegen mechanische Belastung und Zerstörung im funktionellen Kontext mit ihren Nahrungskonkurrenten und Fressfeinden bei gleichzeitiger Minimierung ihres Gewichts, d.h. Optimierung des Energieeinsatzes, besteht. Es sind ca. 60000 Arten Kieselalgen in zwei Ordnungen bekannt, die aufgrund ihrer Schalengeometrie in zentrische (centrales) und pennate (pennales, bogenförmige) unterschieden werden. Die skelettartigen Stützgerüste der Kieselalgen sind aus Kieselsäure gebildet, den Sauerstoffsäuren des Siliziums SiO₂·nH₂O. Je nach Wasseranteil spricht man von Ortho-, Orthodi- oder Metakieselsäure. Ohne Wasser bleibt Kieselsäureanhydrid SiO₂ übrig. Kieselalgen erzielen mit einem Minimum an Material ein Maximum an Stabilität und haben somit die gleiche Zielsetzung wie moderne Leichtbaukonstruktionen. Als Hintergrund seien noch die Internet-**Veröffentlichung IV** ("Wunderschöne Kieselalgen: Muster für stabile Konstruktionen", Alfred-Wegener-Institut für Polar- und Meeresforschung, http://www.awi-bremerhaven.de/AWI/Presse/PM/030219 diatomeen-d.html) mit einigen technischen Daten zu Diatomeen und die Internet-**Veröffentlichung V** ("Jugendstil im Meer", Forschungszentrum Jülich, http://fz-juelich.de/portal/index.php?jahr=2003&index=281 &cmd=show& mid=125) mit Fotos zu der Standardtestmethode mit Glasnadeln zur mechanischen Festigkeit von biomineralisierten Einzellern genannt.

In der klassischen Konstruktion wird zunächst eine den technischen Anforderungen der zu erstellenden Struktur möglichst weit angenäherte Zeichnung erstellt. Dazu ist ein auf diesem technischen Gebiet versierter Konstrukteur erforderlich. Die konstruierte Struktur wird anschließend als Erstmodell mit geeigneten Fertigungsmethoden hergestellt und geprüft. Erfüllt sie die gestellten Anforderungen, d.h. hält sie den Belastungen für die gewünschte Lastspielzahl und/oder Lebensdauer ohne die Funktion beeinträchtigende Veränderungen stand, wird sie ungesetzt und geht so gegebenenfalls in Serie. Anderenfalls wird sie an den kritischen Stellen verstärkt. Eine Schwächung an überdimensionierten Stellen erfolgt hier nicht, da diese in der Regel nicht bekannt werden. Ein fortschrittlicher Konstruktionsprozess optimiert die Struktur, indem ein FEM-Modell erzeugt und am Computer unter den geforderten Stresssituationen getestet und gegebenenfalls verbessert wird. Regelmäßig erfolgt hier aber auch nur ein Spannungsabbau durch Verstärkung. Die Methode dient nicht der Optimierung im allgemeinen, d.h. ökologisch-energetischen Sinne, sondern verfolgt das Ziel, Versuch-und-Fehler-Schritte zu vermeiden und stellt somit nur eine Optimierung in Hinsicht auf die Entwicklungszeit dar. Darüber hinaus werden in der klassischen Konstruktionslehre kaum jemals ganze Systeme aus mehreren Bauteilen optimiert. Aus den Veröffentlichungen I, II und III wird aber deutlich, dass es im allgemeinen Interesse liegen muss, energetisch optimierte Strukturen, insbesondere Leichtbaustrukturen, zu entwickeln. Mit den herkömmlichen Methoden ist dieses Ziel nur mit hohen Aufwendungen an Rechenzeit und -kapazität möglich. Es wird also erkennbar, dass ein ganz entscheidender Schritt zur ökologischen Entwicklung mechanisch hoch belastbarer Strukturen die Erstellung des Erstmodells darstellt. Je näher ein solches Erstmodell an die geforderten Bedingungen heranreicht, desto einfacher ist die Anpassung und Optimierung auf eine rationell fertigbare, energetisch optimale Konstruktion. Dies ist einem Konstrukteur höchstens auf einem jeweils sehr eng begrenzen Spezialgebiet und nur für einzelne Bauteile oder sehr einfache Systeme möglich. Hochgenaue Erstmodelle komplizierter Strukturen auf den unterschiedlichsten Gebieten können so also nicht erstellt werden.

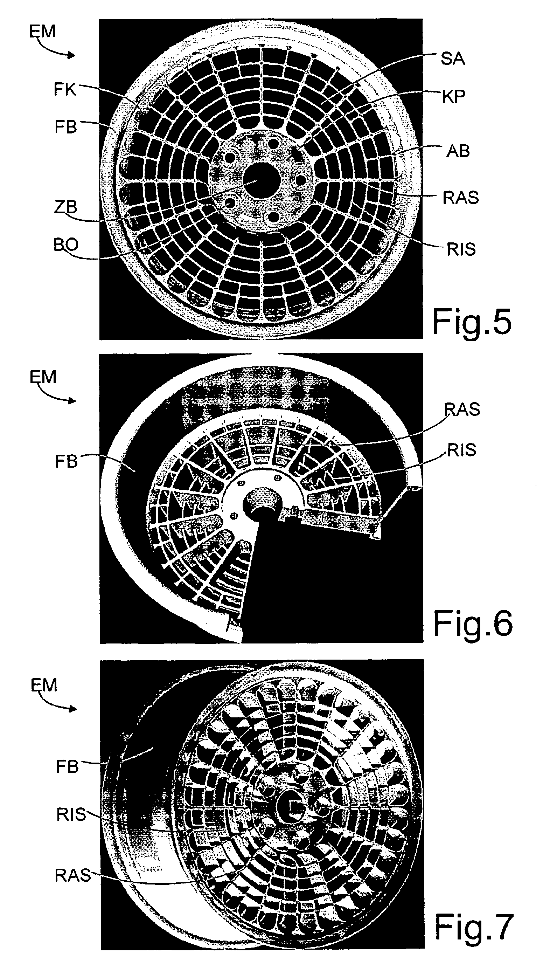

In der **Veröffentlichung VI** von R. Meske et al.: Topologie- und Gestaltoptimierung mit CAOSS und ABAQUS" (XP-002328332, ABAQUS-Anwendertreffen 2000, Winterthur, im Internet abrufbar unter www.fe-design.de/fileadmin/publikationen/publikationen2000/2000-09-29_ABAQUS_Anwendertreffen_Paper.pdf, Stand 17.05.2005) werden spezielle Designwerkzeuge vorgestellt, mit denen der Entwicklungsingenieur bereits in der Konzeptionsphase eine nahezu optimalen Designvorschlag erhalten kann. In der Abbildung 5 ist modellhaft die Integration der Topologie- und Gestaltoptimierung in den Konstruktionsprozess abgebildet. Der Prozess besteht aus mehreren Teilschritten. Hierzu zählt die Modellierung des Bauraums, die anschließende Übertragung in einen FEPreprocessor, die Vorbereitung der Topologieoptimierung in einem Optimierungs-Preprocessor und die darauf folgende Topologieoptimierung. Im Gegensatz zu klassischen Verfahren wird bei der Topologieoptimierung auf keine konstruierte Variante zurückgegriffen, sondern nur der verfügbare Konstruktionsraum definiert. Das Optimierungsverfahren verteilt das Material automatisch entsprechend der vorgegebenen Zielfunktion und Restriktionen. Auf diese Weise entstehen quasi "Bauteile aus dem Nichts". Das Ergebnis der Topologie- und Gestaltoptimierung mit CAOSS und ABAQUS ist ein nicht geometriebasierender Konstruktionsvorschlag - dieses "LEGO Modell" wird in einem weiteren Schritt in eine glatte Struktur überführt. Anschließen kann eine Feinoptimierung der Struktur mit Hilfe der Gestaltoptimierung erfolgen. Hierbei werden noch vorhandene lokale Schwachstellen beseitigt, wodurch die Lebensdauer der Bauteile erheblich verlängert wird. Das feinoptimierte Modell wird danach in ein geometriebezogenes CAD-Modell überführt, welches schließlich über bekannte Schnittstellen in den Fertigungsprozess zurückgeführt werden kann.

In der deutschen Offenlegungsschrift DE 100 53 299 A1 ("Verfahren zur Konstruktion eines Bauteils und Wischanlagenbauteil") wird beispielhaft das Vorgehen zur Konstruktion von mechanischen Teilen mit rechnerunterstützten Methoden dargelegt. Die Verfahrensschritte umfassen eine gegenständliche Modellkonstruktion (Designraummodell), Beschreibung des Modells mit finiten Elementen und Einsatz eines 3D-Programms zur Erstellung eines Datenmodells. Weiterhin werden Verfahrensschritte zur Topologie- und Shape-, d.h. Form-Optimierung angegeben. Die Anmeldung zeigt exemplarisch, wie aufwändig der Erwerb von Daten für ein Erstmodell ist. Die Methodik, ein gegenständliches Modell zu erzeugen und dann eine Zeichnung, d.h. heute häufig ein Datenmodell, oder umgekehrt, zunächst eine Zeichnung und dann, ggf. rechnerunterstützt, ein gegenständliches Modell, um anschließend numerische Optimierungen anzuwenden, kommt in einer Vielzahl von Varianten zum Einsatz, ohne Ansätze für den verbesserten Erwerb von Erstmodelldaten zu bieten.

Die genannten Veröffentlichungen geben kein rationelles Verfahren zum Erstellen eines geeigneten Erstmodells an, mit dessen Hilfe die erforderliche Optimierungsarbeit an einer energetisch besonders vorteilhaften Leichtbaustruktur minimiert werden kann. Der unmittelbare Schritt vom technisch-biologischen Studium natürlicher Architekturen und Verfahren im Rahmen von bionisch ausgelösten Analogieuntersuchungen wird nicht beschrieben, ist also dem zweckgerichteten interdisziplinären Team von Biologen und Technikern überlassen. Das zu wählende Verfahren richtet sich dabei nach dem Gegenstand der Untersuchung und den technischen Möglichkeiten der Beteiligten. Eine verallgemeinerte Methodik, die sich auf viele verschiedene Anforderungsprofile anpasst, wird nicht vorgestellt. Es ist daher die **Aufgabe** der vorliegenden Erfindung, ein rechnergestütztes Verfahren zur Erstellung von Erstmodelldaten für eine technische Leichtbaustruktur anzugeben, das besonders rationell, aber trotzdem zuverlässig arbeitet. Das anzugebende rechnergestützte Verfahren soll zeitlich und wirtschaftlich so effektiv wie möglich Erstmodelldaten zur Verfügung stellen, mit deren Hilfe ein den technischen Anforderungen an die zu erstellende Leichtbaukonstruktion gut angenähertes Erstmodell erstellt werden kann.

Die **Lösung** stellt das erfindungsgemäße rechnergestützte Verfahren mit folgenden rechnergestützten Verfahrensschritten dar:
1. Bereitstellung der relevanten Grundparameter der zu erstellenden technischen Leichtbaustruktur in Bezug auf die technische Problemstellung,
2. Vorauswahl von einem oder mehreren biomineralisierten Einzellern mit zu den bereitgestellten Grundparametern passenden natürlichen Schalenarchitekturen,
3. Auswahl von einer oder mehreren Feinstrukturen der für eine technische Realisierung aussichtsreichsten Bereiche der vorausgewählten Schalenarchitekturen,
4. direkte Abnahme der konstruktiven Daten von den ausgewählten Feinstrukturen,
5. Skalierung der abgenommenen konstruktiven Daten auf die Grundparameter der zu erstellenden technischen Leichtbaustruktur,
6. Kombination und Anpassung der skalierten konstruktiven Daten zu eine Satz von Erstmodelldaten für ein Erstmodell der zu erstellenden technischen Leichtbaustruktur und
7. Optimierung des Erstmodells.

Zur Lösung der gestellten Aufgabe bietet sich der Reichtum an Formen, Funktionen und Verfahren der Natur mit ihren auf evolutionäre Weise erworbenen Erfahrungen an. Die Schalenarchitekturen der biomineralisierten Einzeller verfügen dabei über einen besonders großen Fundus an technisch relevanten Varianten. Nach Werner Nachtigall, einem der Begründer der wissenschaftlichen Bionik, liefert die Natur zwar keine unmittelbar verwendbaren Vorlagen für den technischen Einsatz. Vielmehr muss das biologisch-technische Studium der natürlichen Strukturen ein Verständnis für die Lösungswege der betrachteten Organismen liefern und dieses dann auf das technische Problem angewendet werden. Das erfindungsgemäße rechnergestützte Verfahren stellt dieses Prinzip auch nicht in Frage, sondern greift aus der Vielzahl der möglichen Organismen lediglich eine große, aber hinsichtlich seiner grundsätzlichen Eigenschaften eng begrenze Gruppe heraus, schafft damit einen ebenfalls eng begrenzen Bereich der Untersuchungsmethodik und bezieht deren verallgemeinerte Vorgehensweisen mit ein. Dadurch wird ein Pool von Vorlagen bereitgestellt, der zwar nicht unmittelbar zugänglich ist, jedoch mit Hilfe des rezeptartig eingesetzten rechnergestützten Verfahrens rationell angewendet werden kann. In Kenntnis der an die zu schaffende Leichtbaustruktur gestellten Anforderungen werden zunächst die gewünschten Eigenschaften definiert. Mit diesen wird eine Vorauswahl an geeigneten biomineralisierten Einzellern getroffen. Aus der Auswahl wird mit weiteren gewünschten Eigenschaften eine weitere Auswahl von Unterstrukturen und einzelnen Strukturelementen getroffen. Deren konstruktive Daten werden direkt ermittelt, die diversen Elemente kombiniert und eine Anpassung der Grenzbereiche vorgenommen. Die so entstandene integrierte Struktur wird nach den allgemeinen Regeln der Mechanik auf die geforderten Maße skaliert und damit die Daten für ein Erstmodell in einfacher Weise bereitgestellt. Ein aufwändiges Berechnen der Erstmodelldaten entfällt somit und der zeitliche und kapazitive Rechenaufwand verringert sich bedeutsam. Ein anschließend angewendetes Optimierungsverfahren sorgt für die Ausgestaltung bis zur gewünschten technischen Leichtbaustruktur. Besonders vorteilhaft ist der zumindest halbautomatische Erwerb von konstruktiven Daten anhand standardisierter Untersuchungsmethoden. Der Einsatz numerischer Verfahren zur Speicherung und Auswahl von Datensätzen der biomineralisierten Einzeller, ihrer Schalenarchitekturen und deren konstruktiver Daten einerseits sowie der Daten zu den Methoden der Skalierung, Kombination und Anpassung, der Erstmodelle und deren Optimierungsergebnissen andererseits ist ebenfalls besonders vorteilhaft. Nähere Einzelheiten zum erfindungsgemäßen rechnergestützten Verfahren und seinen vorteilhaften Weiterbildungen sind dem speziellen Beschreibungsteil zu entnehmen.

Nachfolgend wird die Erfindung in ihrem gesamten Umfang anhand der schematischen **Figuren** zu ihrem weiteren Verständnis näher erläutert. Dabei zeigt:
- **Figur 1**: ein Blockdiagramm des rechnergestützten Verfahrens,
- **Figur 2**: Schalenstrukturen von *Diatomeen,*
- **Figur 3**: Schalenstrukturen der *Diatomeen Asterolampra* (links), *Asteromphalus* (zweimal Mitte) *und Arachnoidiscus* (rechts)
- **Figur 4**: eine SEM-Aufnahme (links), ein CAD-Modell (Mitte) und ein FE-Modell (rechts) von *Arachnoidiscus,*
- **Figur 5**: ein mit dem rechnergestützten Verfahren erzeugtes Erstmodell für eine Leichtbaufelge in frontaler Vorderansicht mit einem Ausschnitt,
- **Figur 6**: das Erstmodell gemäß Figur 6 in perspektivischer Rückansicht mit einem Ausschnitt,
- **Figur 7**: das Erstmodell gemäß Figur 6 in perspektivischer Seitenansicht mit einem Ausschnitt,
- **Figur 8**: Schalenstrukturen von *Phaeodarien* (ungeeignet),
- **Figur 9**: Schalenstrukturen von *Phaeodarien* (geeignet),
- **Figur 10**: Details zum inneren Aufbau der Schalen der *Phaeodarien*
- **Figur 11**: ein mit dem rechnergestützten Verfahren erzeugtes Erstmodell für einen Leichtbaustoff als Flächenmodell (links) und als Linienmodell (rechts)
- **Figur 12**: Details zum inneren Aufbau der Schalen der *Coscinodiscus wailesii*
- **Figur 13**: ein mit dem rechnergestützten Verfahren erzeugtes Erstmodell für eine permeable Leichtbauschale als fraktales Schichtenmodell (links) und im Ausschnitt (rechts).

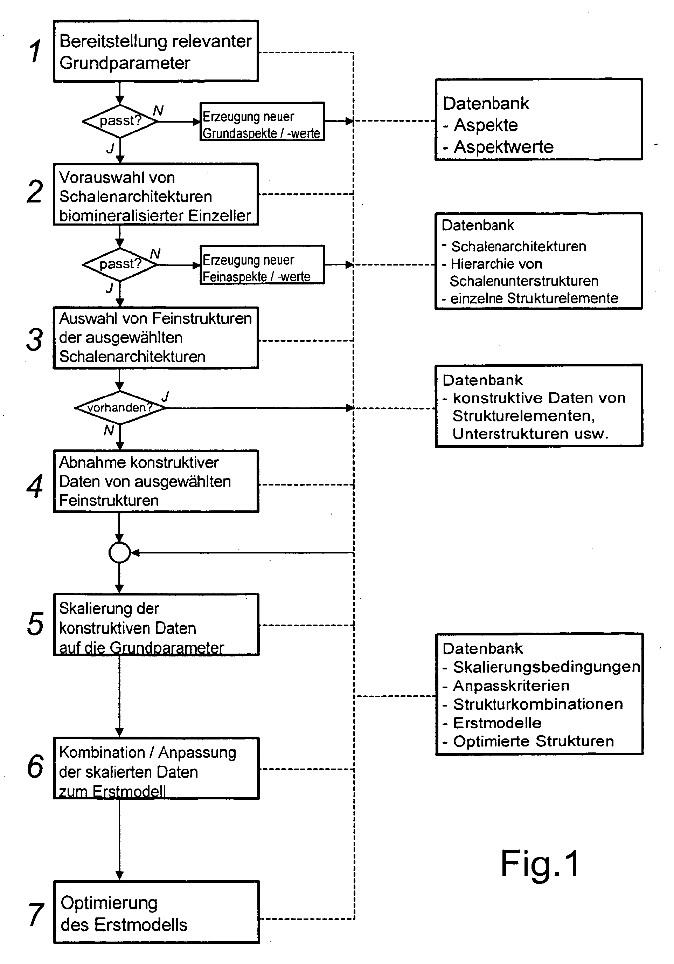

Bei dem im Blockdiagramm gemäß der **Figur 1** dargestellten **Verfahrensschritt 1** wird die gewünschte technische Leichtbaustruktur bezüglich ihrer Eigenschaften in Bezug auf die technische Problemstellung genau beschrieben. Als Grundlage dafür können gemeinsame beschreibende Eigenschaften technischer Leichbaustrukturen und Schalenarchitekturen biomineralisierter Einzeller als organisierte Sammlung von Aspekten und Aspektwerten in einer Datenbank abgelegt sein. Zur Beschreibung der Eigenschaften wird dann ein nach informationstechnischen Gesichtspunkten indizierter Aspektkatalog verwendet, dessen Elemente wohldefinierte Werte annehmen können. Je umfassender ein Aspektkatalog angelegt ist und je besser es gelingt, den gesamten betrachteten Problembereich damit abzudecken, desto genauer kann das jeweils spezielle technische Problem beschrieben werden. Im Zuge häufiger Verwendung kann ein gut gepflegter Aspektkatalog wachsen und immer präziseren Anforderungen gerecht werden. Im vorliegenden Fall der Ermittlung von Erstmodelldaten technischer Leichtbaustrukturen spielen unter anderem Aspekte der Begrenzung des Raums, in dem sich die Konstruktion bewegen darf, der statischen und dynamischen Belastung der Struktur, sowie Vorgaben bezüglich der Gewichtsrelationen von Bauteilen oder ästhetische Gesichtspunkte eine wichtige Rolle.

Für die Lösung ähnlicher Aufgaben kann erwartet werden, dass bereits verwendete Unterstrukturen erneut zum Einsatz kommen können. Für eine Erstmodellerstellung einmal gefundene Daten können in wirtschaftlicher Weise wieder verwendet werden, wenn eine Hierarchie von aufeinander aufbauenden und kombinierbaren Unterstrukturen vorgehalten wird. Auf diese Weise können je nach Erfordernis kleine oder größere, in der Hierarchie höher stehende Unterstrukturen beliebig kombiniert und die Erstmodellerstellung beschleunigt werden. Im **Verfahrensschritt 2** kann mit Hilfe eines anhand einer genauen Definition des technischen Problems mit passenden Werten gefüllten Aspektsatzes einer nach diesen Kriterien sortierbaren Menge von Feinstrukturen natürlicher Schalenarchitekturen eine passende Untermenge entnommen werden. Dazu kann vorteilhaft eine Ablage einer durch ihre bekannten Eigenschaften charakterisierten Hierarchie einzelner Strukturelemente, größerer Unterstrukturen und ganzer Schalenarchitekturen biomineralisierter Einzellern als organisierte Sammlung in einer Datenbank dienen. In diesem Verfahrensschritt 2 wird zunächst mit einer Grundmenge von Aspekten eine Vorauswahl getroffen. Steht für eine gewünschte Eigenschaft kein passender Aspektwert oder sogar kein passender Aspekt zur Verfügung, muss eine nach den übrigen Kriterien ausgesuchte Untermenge von natürlichen Schalenarchitekturen für einen weiteren Überlegungsschritt herangezogen werden. Hierin wird festgelegt, wie eine Methode definiert werden kann, um die Erweiterung des Wertebereichs eines vorhandenen oder die Ermittlung der Werte eines neuen, das aufgeworfene Teilproblem beschreibenden Aspekts zu ermöglichen.

Der **Verfahrensschritt 3** verfeinert die Suche nach geeigneten Feinstrukturen, indem er aus der Menge der prinzipiell geeigneten Schalenarchitekturen durch eine eingegrenzte Untermenge von Aspekten oder weitere Einschränkung der Wertebereiche bestimmter Aspekte besonders geeignet erscheinende Schalenarchitekturen, Unterstrukturen oder Strukturelemente daraus bestimmt. Lösungen aus dem Bereich der hier betrachteten Schalenarchitektur biomineralisierter Einzeller für auftretende Grundfragen der technischen Mechanik, z.B. der Spannungsverhältnisse in Problemzonen der gewünschten technischen Leichtbaustrukturen, können durch die aspektive Beschreibung als Katalog ständig wieder verwendbarer Teillösungen in einer Datenbank hinterlegt werden. Einzelne Strukturelemente, größere Unterstrukturen und Kombinationen daraus können in einer hierarchischen Weise aspektiert und ebenfalls zur Wiederverwendung in einer Datenbank hinterlegt werden. Mit Hilfe der in den Verfahrensschritten 1 bis 3 dargestellten Methodik gelingt es, auf der Basis einer möglicht genauen und umfassenden Aspektierung des Problems aus den Datenbeständen schnell zu passenden Teillösungen zu gelangen. Es stehen dann auch die zugehörigen konstruktiven Daten der ausgewählten Teillösungen zur Verfügung.

Sofern aus den Datenbeständen keine ausreichend genauen Teillösungen bestimmt werden können, müssen im **Verfahrensschritt 4** standardisierte Untersuchungsmethoden zur Bestimmung von mechanischen Grundeigenschaften auf die bis zu diesem Schritt bestimmten übergeordneten Strukturen, ggf. komplette Schalenarchitekturen angewendet werden. Dazu müssen im ursprünglichsten Fall neue biomineralisierte Einzeller im Bestand der Natur gefunden und katalogisiert oder bereits katalogisierte auf ihre Eignung und ihre konstruktiven Daten untersucht werden. Der Erwerb der konstruktiven Daten von den Feinstrukturen der Schalenarchitekturen ist ein zeitaufwändiger Arbeitsgang. Daher kann das rechnergestützte Verfahren nach der Erfindung vorteilhaft mit einer direkten Abnahme der konstruktiven Daten von den ausgewählten Feinstrukturen oder Unterstrukturen durch zumindest halbautomatisches mikroskopisches Scannen durchgeführt werden. Die Abmessungen der Schalenstrukturen liegen im Bereich von einigen Nanometern für die unterste Hierarchieebene von Unterstrukturen bis über einen Millimeter für komplette Schalen. Für eine hochauflösende bildliche Darstellung kommen daher verschiedene elektronenmikroskopische Aufnahmeverfahren in Frage. Um dreidimensionale Strukturdaten zu erhalten, sind mehrere Aufnahmen aus verschiedenen Perspektiven oder entsprechende räumliche Aufnahmesysteme erforderlich. Bei Kenntnis der Relationen der Aufnahmewinkel zueinander kann ein Rechenprogramm die digitalisierten Mikroskopie-Pixelbilder in Vektoren umrechnen und damit skalierbare Daten zur weiteren Verarbeitung in Richtung auf die gewünschte Erstmodellbildung liefern. Eine Möglichkeit zur Generierung von 3D-Strukturmodellen besteht im Einsatz eines Laser-Konfokalmikroskops, das einzelne Schichten mikroskopischer Schalenstrukturen darstellt. Durch Rechenprogramme können daraus räumliche Darstellungen der originalen Strukturen rekombiniert und skalierbare Daten für die Erstmodellbildung bereitgestellt werden. Dabei ist es wiederum hilfreich, wenn die direkt abgenommenen konstruktiven Daten als organisierte Sammlung in einer Datenbank abgelegt werden. Die Wiederverwendung der aufwändig erworbenen Daten ist nahe liegend, da zur Lösung immer wieder ähnlicher Probleme auch immer wieder gleiche oder ähnliche Unterstrukturen eingesetzt werden können. Stresstests, z.B. der Glasnadeltest (siehe Veröffentlichungen III, IV, V), geben darüber hinaus Aufschluss über die mechanische Belastbarkeit der Schalenarchitekturen.

im **Verfahrensschritt 5** werden die gewonnenen Daten auf die Größenverhältnisse der zu erstellenden technischen Leichtbaustruktur skaliert. Im Falle von statischen oder quasistatischen Belastungsverhältnissen ist eine solche einfache Hochrechnung zulässig. Bei hauptsächlich stark dynamisch beanspruchten Teilen, deren Verhältnisse nicht durch quasistatische Annahmen oder direkte Analogien zu Schalenarchitekturfragmenten angenähert werden können, müssen gegebenenfalls andere Skalierungsmethoden angewendet werden. Im **Verfahrensschritt 6** werden alle Unterstrukturen zu der gewünschten technischen Leichtbaustruktur zusammengefasst und die Stoßstellen geglättet. Das Ergebnis sind die Daten eines Erstmodells, das sehr eng an ein passendes Spektrum von Naturvorlagen angelehnt ist und damit der angestrebten Leichtbaukonstruktion schon sehr nahe kommt. Auch hierbei ist eine Ablage von Kriterien für die Skalierung, die Kombination und die Anpassung der konstruktiven Daten, von Erstmodellen und deren Optimierungsergebnissen als organisierte Sammlung in einer Datenbank von Vorteil.

Im **Verfahrensschritt 7** schließlich wird das Erstmodell zu einem ausgereiften mechanischen System optimiert. Hierzu können unterschiedliche Optimierungsverfahren zum Einsatz kommen, z.B. die in der Veröffentlichung II bereits vorgestellten SKO- und CAO-Verfahren.

### Ausführungsbeispiel 1 - Rechnergestützte Ermittlung von konstruktiven Daten eines Erstmodells für eine Leichtbaufelge

### 1. Bereitstellung der Grundparameter der zu erstellenden technischen Leichtbaustruktur in Form einer Leichtbaufelge

Die geforderte Leichtbaustruktur ist ein Rad, bestehend aus einem inneren Felgenkörper und einem damit verbundenen äußeren Felgenbett, wobei der Felgenkörper über Befestigungsmittel mit der Fahrzeugachse und das Felgenbett mit dem Reifen verbunden sind. Allgemein wird die Summe dieser Elemente als "Felge" bezeichnet. Weiterhin soll diese Felge aus faserverstärktem Kunststoff mit anisotropen Materialeigenschaften bestehen.

Im vorliegenden Fall einer Leichtbaufelge ist eine Gewichtsredzierung gewünscht, weil Felgen als ungefederte Massen möglichst leicht sein müssen, um besseren Bodenkontakt zu halten und auch auf unebener Fahrbahn effektiv zu haften. Eine besondere Herausforderung ist daher das Material, dessen Materialeigenschaften einen Einfluss auf die Auswahl geeigneter Geometrien hat. Da das Felgenbett und die Befestigungselemente genormt sind, sind Verbesserungen vor allem im Bereich des Felgenkörpers zu erzielen. Als zusätzliche Forderung ist eine gute Luftdurchlässigkeit in diesem Bereich zu nennen, um eine effektive Kühlung von Scheibenbremsen zu ermöglichen

### 2. Vorauswahl von biomineralisierten Einzellern mit passenden natürlichen Schalenarchitekturen

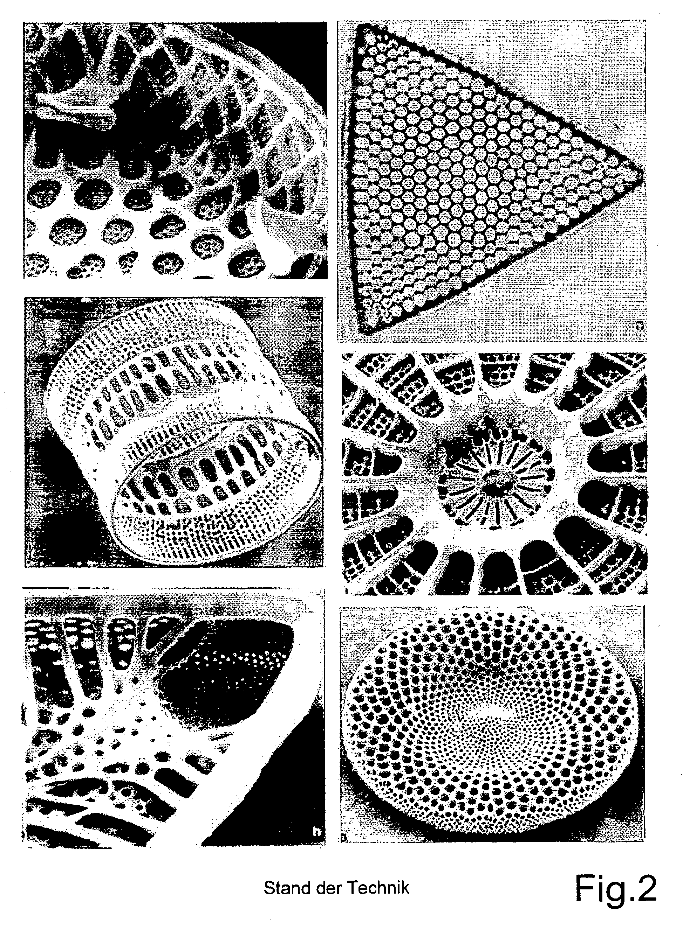

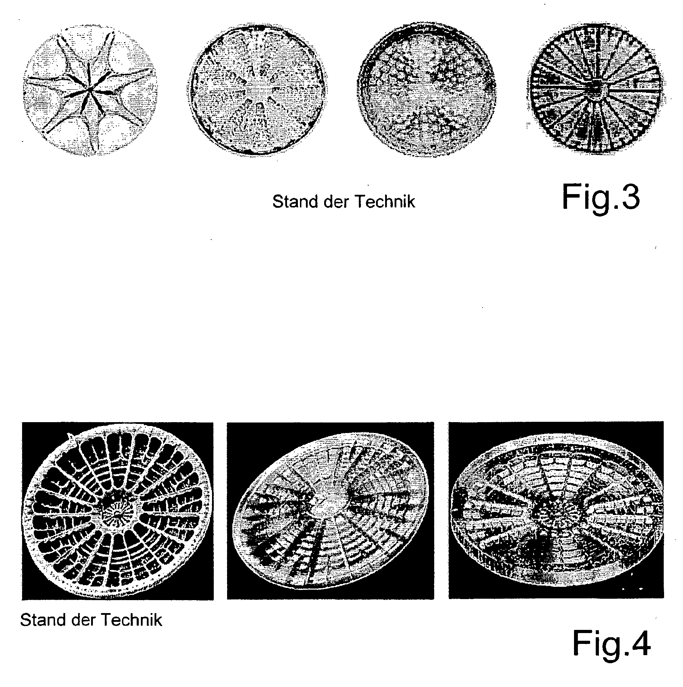

Aus den Organismen mit biologischen Leichtbauschalen (insbesondere planktonische, biomineralisierte Einzeller) wird die Gruppe der *Diatomeen* selektiert, da in dieser Gruppe Arten mit Schalengeometrien (vergleiche **Figur 2**) vertreten sind, die die fundamentalen Voraussetzungen für eine bionische Verbesserung eines Leichtbaurades erfüllen, also bereits relativ flach und radartig sind. Sehr viele entsprechende Gattungen wie *Thalassiosira, Porosira* oder *Coscinodiscus* kommen als Lösungsansatz für die vorliegende Problemstellung dennoch nicht in Frage, da diese keine extrahierbaren Strukturelemente aufweisen. Als besonders geeignete Geometrien werden dagegen die von zentrischen Kieselalgen wie *Asterolampra* (vergleiche **Figur 3**, links), *Asteromphalus* (vergleiche **Figur 3**, zweimal Mitte) und *Arachnoidiscus* (vergleiche **Figur 3**, rechts) ausgewählt, die jeweils radialsymmetrische, versteifende Strukturelemente enthalten. Kieselalgen sind in der Natur unterschiedlichen Belastungen ausgesetzt, die in ihrer Vielfalt den Lastfällen ähneln, die auch an Felgen auftreten. Ein Setektionsdruck hin zu leichter Bauweise besteht außerdem wegen des limitierten Angebots an Baustoff (Silikat) sowie der Notwendigkeit, die Strukturen effektiv (schnell und mit wenig Energieaufwand) zu produzieren. Der Zwang, die Schalen leicht zu konstruieren ist zudem durch die planktonische (schwebende) Lebensweise vieler Kieselalgen gegeben. Durch evolutive Anpassungsprozesse in ca. 200 Millionen Jahren haben die Kieselalgen ihre schalen als ultraleichte Defensivstrukturen ausgebildet, was zu hoch entwickelten, z.T. sehr komplexen Leichtbaustrukturen geführt hat. Wie FE-Berechnungen ergeben haben, bestehen die schalen der Kieselalgen aus einem anisotropen material und erreichen dadurch maximale Festigkeit bei minimalem Materialseinsatz.

Kieselalgen sind als einzellige Organismen in der Regel unter einem Millimeter groß. Von Vorteil für die Übertragung in den technischen Bereich ist dabei, dass die Form ihrer Schalen skalierbar ist, das heißt, sie kann maßstabsgerecht vergrößert werden und behält trotzdem ihre spezifische Festigkeit, da Materialquerschnitt und Flächenbelastung beide mit dem Quadrat des Längenmaßstabes skalieren. Ihre Formen erscheinen zwar außergewöhnlich, aber nicht fremd oder skurril, sie sind im Gegenteil sehr harmonisch und ästhetisch. Wegen ihrer ausgewogenen Formen widersprechen sie trotz einer im Felgenbau neuartigen Strukturierung auch nicht unseren Sehgewohnheiten, was bei einem hochwertigen Massenprodukt wie einer Leichtbaufelge eine wesentliche Voraussetzung für die Annahme durch die Käuferschaft ist.

Trotz interessanter Lösungsansätze in den Schalenstrukturen all dieser Gattungen/Arten der *Diatomeen* bietet *Arachnoidiscus* eine bessere Umsetzbarkeit als *Asterolampra,* da der spätere Produktionsprozess für eine Leichtbaufelge Unterschneidungen, die bei *Asterolampra* vorherrschen, nicht zulässt. Die Gattung *Asteromphalus* besitzt radiär gewellte Schalen, die ausschließlich aus einer mit sehr feinen Poren durchsetzten Schale gebildet wird. Wegen der geforderten Durchlässigkeit der Struktur kann diese Lösung nicht in Betracht gezogen werden. Auch im Hinblick auf die anisotropen Materialeigenschaften des faserverstärkten Kunststoffes sind die Strukturelemente von *Arachnoidiscus* von Vorteil, da die zu erwartenden Spannungsverläufe in derartigen Strukturen im Wesentlichen den durch den Produktionsprozess vorwiegend erzeugten Faserverläufen angepasst sind (hohes Aspektverhältnis - Breite zu Tiefe - der auftretenden Rippen). Das dabei potenziell auftretende Problem der Knickung der sehr dünnen speichenartigen Elemente wird durch die in geringen Abständen angelegten konzentrischen Elemente kompensiert. Die **Figur 4** zeigt links eine SEM-Aufnahme, in der Mitte ein CAD-Modell und rechts ein FE-Modell von *Arachnoidiscus.* In diesem Stadium des Ermittlungsverfahrens sind die Mittel- und Randbereiche der Strukturen noch an der Geometrie der Mikroalge orientiert, zudem ist die Struktur noch durch porenartige Ausfüllungen geschlossen.

Teil der Vorauswahl von biomineralisierten Einzellern mit passenden natürlichen Schalenarchitekturen gemäß dem **Verfahrensschritt 2** ist auch die Durchführung mikromechanischer Tests zur Erfassung mechanischer Eigenschaften. Mikromechanische Tests wurden bereits beispielhaft an zentrischen Diatomeen (*Thalassiosira* und *Coscinodiscus*) durchgeführt. Durch diese Tests, bei denen die Schale von *Diatomeen* von einer Glasnadel unter ansteigenden Druck bis zur Zerstörung gesetzt wird, konnten generell günstige mechanische Eigenschaften von Schalen von *Diatomeen* nachgewiesen werden. Eine Bruchkraft von z.B. 300 µN bei *Thalassiosira* mit einer Größe zwischen 30 und 130 µm entspricht bei einer auf einen Quadratmeter hochskalierten Leichtbaukonstruktion einer Belastbarkeit von mehreren Hundert Tonnen.

### 3. Auswahl von Feinstrukturen der aussichtsreichsten Bereiche der vorausgewählten Schalenarchitekturen

Aus der Gesamtstruktur von *Arachnoidiscus* werden die internen Strukturen in den Valven, nicht jedoch die loculaten Areolen (wabenförmige Strukturen mit extrem kleinen Poren) ausgewählt, da es für die effektive Kühlung der Bremsscheiben notwendig ist, dass ein effektiver Luftaustausch zwischen Innen- und Außenseite des Felgenkörpers stattfindet. Der gerüstartige innere Aufbau besteht bei *Arachnoidiscus* aus radiären und konzentrischen Strukturelementen, deren Aspektverhältnis (Breite zu Tiefe einer Rippe) außerordentlich hoch ist.

### 4. Direkte Abnahme der konstruktiven Daten von den ausgewählten Feinstrukturen

Die konstruktiven Daten des Schalenaufbaus werden direkt aus licht- und rasterelektronenmikroskopischen Aufnahmen gewonnen und mit Hilfe von CAD- und FE- Programmen in 3D- Modelle transferiert.

### 5. Skalierung der abgenommenen Daten auf die Grundparameter der Leichtbaufelge

Die Skalierung erfolgt im Wesentlichen auf der Basis der Originalvorlage (*Arachnoidiscus*), wobei lediglich einige für die Produktion sinnvolle Vereinfachungen, wie das Weglassen von Unterschneidungen und die Darstellung der Struktur als vollkommen radiärsymmetrisch, vorgenommen wurden.

### 6. Kombination und Anpassung der skalierten Daten zu einem Satz von Erstmodelldaten für eine Leichtbaufelge

Die radiären und konzentrischen Strukturelemente werden mit dem genormten Bereichen der Radbefestigung sowie Felgenhorn (Wulst an der Vorderseite des Felgenbettes) und -bett vereinigt und geglättet. Das daraus resultierende Erstmodell wird so dimensioniert, dass es Berechnungen für einen direkten Vergleich mit einer aktuellen Leichtbaufelge mit bekannten Eigenschaften zulässt. Als Nebenaspekt wird auch das Design des durch das hier vorgestellte rechnergestützte Verfahren erzeugten Erstmodells evaluiert, indem ein 1:1 Prototyp der Leichtbaufelge stereolithographisch produziert und optimiert wird. Weiter unten werden unterschiedliche Ansichten des fertigen Erstmodells für eine Leichtbaufelge mit integrierter Leichtbaugeometrie auf der Basis der Topologie von *Arachnoidiscus* dargestellt.

### 7. Optimierung des Erstmodells für eine Leichtbaufelge

Anschließend werden die speziellen, für Leichtbaufelgen relevanten Lastfälle mit Hilfe vorgegebener Lastprogramme angewendet, um mit Hilfe von FE-Programmen und Optimierungssoftware eine letzte Anpassung des Erstmodells an die geforderten Leistungsmerkmale einer Leichtbaufelge vornehmen zu können.

### Konkrete Ausführungsform des Erstmodells für eine Leichtbaufelge

Mit dem zuvor erläuterten rechnergestützten Verfahren kann in sehr effizienter Weise ein Erstmodell einer Leichtbaufelge direkt aus dem konkreten Erscheinungsbild von *Arachnoidiscus* entwickelt werden. Dabei besteht eine Leichtbaufelge für ein Kraftfahrzeug aus einem inneren Felgenkörper, der einseitig an einer Achse befestigbar ist, und mit einem mit dem inneren Felgenkörper verbundenen äußeren Felgenbett. In speziellen Ausführungsformen weist der Felgenkörper einen tragenden Speichenaufbau auf.

Das mit dem vorgestellten rechnergestützten Verfahren konzipierte Erstmodell für eine Leichtbaufelge zeichnet sich durch einen hochsymmetrischen und besonders filigranen Aufbau aus, der einen geringen Materialeinsatz ermöglicht und trotzdem durch den hohen Vernetzungsgrad eine hohe Festigkeit, insbesondere gegen Ausknicken der Speichen, garantiert. Im Speichenaufbau werden Radial- und Ringspeichen unterschieden. Dabei sind die Speichen rippenartig ausgeformt, sodass sie von der Erstmodellvorderseite her betrachtet nur einen geringen Raum einnehmen und später eine optimale Belüftung der hinter der nach dem Erstmodell hergestellten Leichtbaufelge liegenden Scheibenbremsen ermöglichen. Die Radialfelgen haben ein hohes Aspektverhältnis in der Breite der Rippen zu ihrer Tiefe. Die Form der Rippe ist damit schmal, aber tief resp. hoch, wodurch sich bereits ein Festigkeitsaspekt ergibt. Der zweite Festigkeitsaspekt ergibt sich aus der kreuzenden Überlagerung der Radialspeichen mit den Ringspeichen, sodass sich alle Speichen gegenseitig abstützen. Es entsteht in Abhängigkeit von der Anzahl der Speichen ein hochsymmetrischer Gesamteindruck des Erstmodells nach der Art eines karierten Papiers mit einem durch die gewählte Rippengeometrie festlegbaren Maschenbild. Dabei wird dieses insbesondere auch dadurch geprägt, dass nicht alle Radialspeichen bis zur Felgenachse durchlaufen, sondern sich einige radiale Radialspeichen nur jeweils über ein Drittel des Felgenkörpers vom Felgenbett her erstrecken. Diese enden dann gemeinsam an einer der äußeren Ringspeichen. Diese Maßnahme, die sich auf symmetrisch angeordnete Radialspeichen, beispielsweise jede dritte Radialspeiche, bezieht, erbringt später bei der Produktion einer Leichtbaufelge eine weitere Verringerung des Felgengewichts, ohne dass die Leichtbaufelge dabei an Festigkeit einbüßt. Das Erscheinungsbild des Speichenaufbaus wird aufgelockert, ohne dass dabei jedoch eine Unruhe entsteht.

Der Speichenaufbau kann völlig symmetrisch sein, wenn die Radial- und die Ringspeichen gleichberechtigt ausgeprägt sind. Eine Ausführungsform des Erstmodells kann aber auch durch ein geringeres Aspektverhältnis der Ringspeichen gegenüber dem Aspektverhältnis der Radialspeichen gekennzeichnet sein, wobei die Ringspeichen mit den Radialspeichen auf der Vorderseite bündig oder nahezu bündig verlaufen. Somit ergibt sich ein spaltendominierter Speichenaufbau, der eine besonders hohe radiale Festigkeit, insbesondere gegen Ausknicken der Radialspeichen, aufweist, trotzdem aber auch umlaufend ausreichend unterstützt ist. Dabei wird der optische Gesamteindruck nicht gestört, wenn die flacheren Ringspeichen an der Vorderseite des Felgenkörpers angeordnet sind, sodass sie bündig oder nahezu bündig mit den Radialspeichen verlaufen und nicht nach hinten versetzt sind. Das direkt aus dem konkreten Erscheinungsbild von *Arachnoidiscus* entwickelte Erstmodell einer Leichtbaufelge kann durch 16 Radialspeichen und 6 Ringspeichen gekennzeichnet sein, wobei jede zweite Radialspeiche nur bis zur zweiten Ringspeiche vom Felgenbett aus verläuft. Hierbei handelt es sich um einen konstruktiven Aufbau, der sich durch theoretische und praktische Untersuchungen als eine besonders vorteilhafte Ausführungsform für eine Leichtbaufelge ergeben hat.

Weitere Modifikationen des Erstmodells können gekennzeichnet sein durch Abrundungen zwischen den Radialspeichen auf der Seite des Felgenbettes und durch eine konzentrische Kreisplatte im Bereich der Achsbefestigung des Felgenkörpers, in die die Radialspeichen auslaufen. Derartige Modifikationen dienen der weiteren Festigkeitssteigerung und können beispielsweise durch Belastungssimulationsprogramme ermittelt werden. Außerdem verbessern sie den optischen Gesamteindruck und die Handhabbarkeit der nach dem Erstmodell hergestellten Leichtbaufelge. Durch die Abrundung der Zwischenräume ist später eine bessere Säuberung und durch die konzentrische Kreisplatte eine bessere Montage gewährleistet.

Die **Figur 5** zeigt ein Erstmodell **EM** für eine Leichtbaufelge für ein Kraftfahrzeug mit einem inneren Felgenkörper **FK** und einem damit verbundenen äußeren Felgenbett **FB**. Auf das Felgenbett **FB** wird im Fall einer realisierten Leichtbaufelge im Betrieb ein Reifen aufgezogen, der Felgenkörper FK weist eine zentrale Bohrung **ZB** auf, mit der er einseitig auf die Autoachse aufgeschoben und mit mehreren Radbolzen durch dafür vorgesehen Bohrungen **BO** befestigt. Der Felgenkörper **FK** weist einen tragenden Speichenaufbau **SA** auf. Der Speichenaufbau **SA** ist hochsymmetrisch ausgeprägt und besteht aus einer Vielzahl von Radialspeichen **RAS** und Ringspeichen **RIS**. Beide Speichenformen sind als rechteckige Rippen ausgebildet und sind relativ schmal, aber lang und tief. Die rippenartigen Radialspeichen **RAS** haben ein besonders hohes Aspektverhältnis. Sie sind sehr schmal ausgebildet und haben eine solche Tiefe, dass eine für den späteren Betrieb ausreichende Festigkeit und Stabilität der Leichtbaufelge erreicht werden kann. Die Tiefe der Radialspeichen **RAS** kann beispielsweise im Bereich von einem Sechstel der Breite des Felgenbetts **FB** liegen. Gekreuzt werden die Radialspeichen **RAS** von mehreren konzentrischen Ringspeichen **RIS**. Diese sind umlaufend geschlossen und in einem konstanten radialen Abstand zueinander angeordnet. Im gewählten Ausführungsbeispiel werden 16 Radialspeichen **RAS** von 6 Ringspeichen gekreuzt. Es entsteht ein engmaschiges Gitter hoher Stabilität. Die Ringspeichen weisen ein geringeres Aspektverhältnis auf als die Radialspeichen **RAS** und dienen in der Hauptsache zu deren Aussteifung. Um ein von der Vorderseite des Erstmodells **EM** her einheitliches Bild zu schaffen, liegen die Ringspeichen **RIS** an der Vorderseite des Felgenbetts **FB** und schließen bündig mit den Radialspeichen **RAS** ab.

Die Hauptlast wird von den Radialspeichen **RAS** getragen. Dabei ist jedoch eine Durchgängigkeit aller Radialspeichen **RAS** bis zur zentralen Bohrung **ZB** nicht erforderlich. Es reicht eine maximale Aussteifung im Bereich des Felgenbettes **FB** aus, weshalb im gewählten Ausführungsbeispiel jede zweite Radialspeiche **RAS** nur bis zur zweiten Ringspeiche **RIS** vom Felgenbett **FB** aus ausgeführt ist. Dadurch ergibt sich zusätzlich noch ein sehr symmetrischer Eindruck eines Felgenkranzes. Dieser wird noch unterstützt durch Abrundungen **AB** zwischen den Radialspeichen **RAS** auf der Seite des Felgenbettes **FB**. Weiterhin ist im Bereich der Achsbefestigung des Felgenkörpers **FK** eine konzentrische Kreisplatte **KP** vorgesehen, in die die Radialspeichen **RAS** auslaufen und die das Gittermuster harmonisch abschließt. Die konzentrische Kreisplatte **KP** nimmt die Bohrungen **BO** für die Radbolzen auf und garantiert eine hohe Stabilität des belasteten Achsbereichs der Leichtbaufelge **LF**.

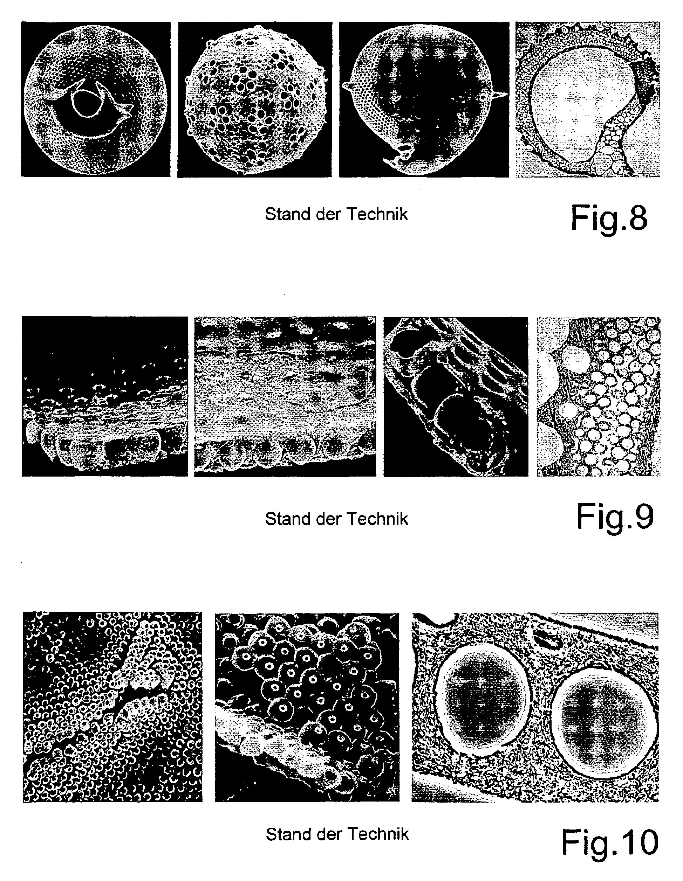

Die **Figuren 6** und **7** zeigen das Ausführungsbeispiel des Erstmodells **EM** gemäß **Figur 5** in der Ansicht von hinten und von der Seite mit jeweils einem Ausschnitt. Die Bezugszeichen sind entsprechend der **Figur 5** zu entnehmen. In der **Figur 6** ist zu erkennen, dass die Radialspeichen **RAS** und die Ringspeichen **RIS** nur an der vorderen Seite des Felgenbettes **FB** angeordnet sind. Zu erkennen ist auch das gegenüber den Ringspeichen **RIS** höhere Aspektverhältnis bei den Radialspeichen **RAS**. In der **Figur 8** sind deutlich die stabile Ausprägung des Felgenbettes **FB** und die rippenartige Ausprägung der Ringspeichen **RIS** zu erkennen.

### Ausführungsbeispiel 2 - Rechnergestützte Ermittlung von konstruktiven Daten eines Erstmodells für einen Leichtbaustoff

### 1. Bereitstellung der Grundparameter der zu erstellenden technischen Leichtbaustruktur in Form eines Leichtbaustoffes

Der geforderte Leichtbaustoff ist eine vollständig oder weitgehend geschlossene Schale, die ein hohes Maß an Flexibilität aufweisen sowie ein starkes Formgedächtnis haben sollte. Diese Eigenschaften müssen bei Bedarf mit einer gewissen Permeabilität gekoppelt werden können. Derartige Strukturen könnten vielfältig in der Automobilindustrie sowie in Luft- und Raumfahrt eingesetzt werden. Die Geometrie soll durch gängige oder leicht zu entwickelnde Produktionsverfahren zu verwirklichen sein. Im vorliegenden Beispiel sollen insbesondere neue rechnergestützte Verfahren der Leichtbauweise, wie die der Herstellung von Metallschäumen und Hohlkugeln, eingesetzt werden.

### 2. Vorauswahl von biomineralisierten Einzellern mit passenden natürlichen Schalenarchitekturen

Aus den Organismen mit biologischen Leichtbauschalen (insbesondere planktonische, biomineralisierte Einzeller) wird die Gruppe der *Radiolarien,* speziell der Untergruppe der *Phaeodarien* selektiert, da in dieser Gruppe Arten mit Schalengeometrien vertreten sind, die die fundamentalen Voraussetzungen für eine bionische Verbesserung dieser Leichtbaustruktur erfüllen. Einzeller wie *Diatomeen* oder die ebenfalls zu den Radiolarien gehörenden *Nasselarien* kommen als Lösungsansatz für die vorliegende Problemstellung nicht in Frage, da diese eine sehr offene Architektur haben. Die **Figur 8** zeigt Raster- und Transmissionselektronenmikroskopische Darstellungen verschiedener weitgehend geschlossener Schalen von *Phaeodarien,* die sich **nicht** für die Erstellung eines Erstmodells für einen Leichtbauwerkstoff eignen.

Als besonders geeignete Geometrien werden dagegen die von Arten wie *Challengeron* identifiziert, da diese sowohl geschlossene Schalen als auch solche mit sehr kleinen Poren besitzen. Die aus produktionstechnischer Sicht aufgestellten Kriterien - der Einsatz bereits entwickelter Produktionsverfahren - können durch eine Kombination aus Hohlkörpern und Schaum zwischen massiven Deckschichten erfüllt werden. Die **Figur 9** zeigt eine Auswahl von Schalenkonstruktionen, die dem Prinzip "Hohlkugeln und Schaum zwischen massiven Schichten" folgen. Auffällig ist, dass die Hohlkugeln meist mit speziellen Strukturen in der massiven Außenschale verankert sind. Trotz interessanter Lösungsansätze in den Schalenstrukturen auch anderer Organismengruppen sind diese in der Regel nicht so gut für die vorliegende Problemstellung geeignet. Während viele biologische Exoskelette mit stachelartigen Fortsätzen bewehrt sind und so ihre rein defensive Schutzfunktion ergänzen, ist dies bei technischen Bauteilen in der Regel nicht erwünscht. *Phaeodarien* besitzen dagegen eine weitgehend glatte Schale, die, wie z.B. auch bei Karrosserieteilen erwünscht, eine passive, defensive Form von Schutz bietet. Der Aufbau der *Phaeodarien* ist auch im Hinblick auf eine mögliche Durchlässigkeit von Interesse, die bei herkömmlichen Strukturen häufig dazu führt, dass der Aufbau für gleiche mechanische Festigkeit erheblich verstärkt wird, um sich möglicherweise ergebende Schwachpunkte zu vermeiden. Verschiedene bei den *Phaeodarien* realisierte Geometrien sind darauf ausgelegt, Spannungsspitzen in diesen Bereichen zu vermeiden.

Mikromechanische Tests ("Nadeltest", vergleiche weiter oben) wurden an antarktischen *Phaeodarien* (*Challengeron*) durchgeführt. Durch diese Tests konnten bereits generell günstige mechanische Eigenschaften der Einzellerschalen nachgewiesen werden, insbesondere lieferten die Versuche Hinweise auf ein hohes Maß an Flexibilität/Pseudoelastizität und Formgedächtnis. Da diese Eigenschaften mit größter Wahrscheinlichkeit nicht allein durch die Eigenschaften des Materials (Silikat), sondern vor allem auch durch den spezifischen Aufbau im µm-Bereich hervorgerufen wird, ist es möglich, die Bauprinzipien auf technische Schalen aus anderen Werkstoffen zu übertragen.

### 3. Auswahl von Feinstrukturen der aussichtsreichsten Bereiche der vorausgewählten Schalenarchitekturen

Aus der Gesamtstruktur der *Phaeodarien* werden die internen Strukturen genauer analysiert. Auffällig ist hierbei, dass durch Vorzugsrichtungen der Elemente des zwischen den Hohlkugeln liegenden schaumartigen Materials eine höhere Festigkeit erzielt wird, als dies bei reinen isotropen Schäumen der Fall ist (vergleiche Figur **9**). Die **Figur 10** zeigt Details zum inneren Aufbau der Schalen der *Phaeodarien.* In der **Figur 10** links und Mitte sind angelöste Schalen dargestellt, die zeigen, dass zwischen einzelnen Hohlelementen keine starre Verbindung besteht. Das völlige Fehlen einer Schaummatrix weist auf deutliche materialspezifische Unterschiede zwischen Schaum- und Hohlelementen hin. Zusätzlich sind auf der äußeren Seite der Hohlelemente Verstärkungen um die Poren herum zu sehen. In der **Figur 10** rechts ist ein TEM-Schnitt dargestellt. Die Anwesenheit der Hohlkugeln verursacht eine topologische Anisotropie in der Schaummatrix.

### 4. Direkte Abnahme der konstruktiven Daten von den ausgewählten Feinstrukturen

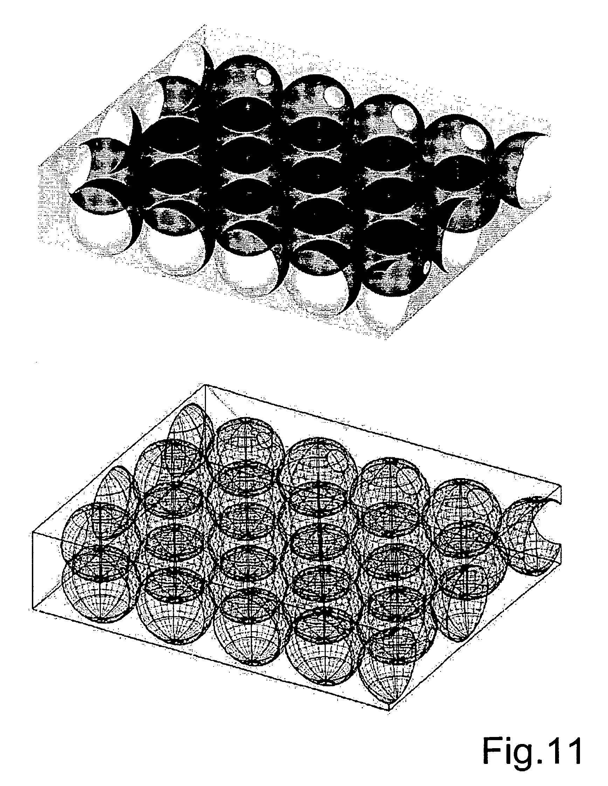

Die Daten werden direkt aus licht- und rasterelektronenmikroskopischen Aufnahmen gewonnen und mit Hilfe von CAD- und FE- Programmen in 3D-Modelle transferiert. Die **Figur 11** links zeigt ein erstes Erstmodell in der Anfangsform von Hohlkugeln in Matrix als Flächen- und Linienbild. Ausgehend von diesem 3D- Modell werden verschiedene Varianten entwickelt und mit Hilfe von FE-Analysen auf verschiedene physikalische Charakteristika getestet.

### 5. Skalierung der abgenommenen Daten auf die Grundparameter des Leichtbaustoffes

Die Skalierung erfolgt im Wesentlichen auf der Basis der Originalvorlage, was durch die spezifischen Ähnlichkeitsgesetze für Schalen ermöglicht wird.

### 6. Aufbereitung der skalierten Daten zu einem Satz von Erstmodelldaten für einen Leichtbaustoff

Die Aufbereitung orientiert sich and den produktionstechnischen Möglichkeiten zur Erzeugung von Prototypen und ggf. einem serientauglichen Produktionsverfahren.

### 7. Optimierung des Erstmodells

Anschließend werden die speziellen, für Leichtbaufelgen relevanten Lastfälle mit Hilfe vorgegebener Lastprogramme angewendet, um mit Hilfe von FE-Programmen und Optimierungssoftware eine letzte Anpassung des Erstmodells an die geforderten Leistungsmerkmale einer Leichtbaufelge vornehmen zu können.

### Ausführungsbeispiel 3 - Rechnergestützte Ermittlung von konstruktiven Daten eines Erstmodells für permeable Leichtbauschale

### 1. Bereitstellung der Grundparameter der zu erstellenden technischen Leichtbaustruktur in Form einer permeablen Leichtbauschale

Die geforderte Leichtbaustruktur ist eine sehr leichte, gasdurchlässige, aber lokal und in der Gesamtstruktur stabile Schale, die im vorliegenden Fall speziell auf Computergehänse zugeschnitten ist. Ein grundlegendes Anforderungsprofil für Computergehäuse, insbesondere von Laptops, besteht in einer Kombination von hoher Festigkeit, geringem Gewicht, geringer Geräuschentwicklung und hoher Luftdurchlässigkeit, um eine ausreichende Kühlung zu gewährleisten. Insbesondere durch die Zunahme der Taktfrequenz neuer Prozessoren und Graphikchips, und des damit verbundenen Energieumsatzes wird die Wärmeproduktion der Rechner zu einem generellen Problem. Besonders extrem ist der Bedarf an diesen Eigenschaften bei Laptops, deren Taktfrequenzen wegen drohender Überhitzung abgeregelt werden, da auch der Einsatz von Lüftungssystemen wegen des damit verbundenen hohen Energiebedarfs stark limitiert ist bzw. den Geräuschpegel erheblich in die Höhe treibt. Die Geometrie soll durch gängige oder leicht zu entwickelnde Produktionsverfahren zu verwirklichen sein. Im vorliegenden Beispiel sollen insbesondere neue Verfahren der Leichtbauweise, wie das der Hohlkugelverwendung, eingesetzt werden.

### 2. Vorauswahl von biomineralisierten Einzellern mit passenden natürlichen Schalenarchitekturen

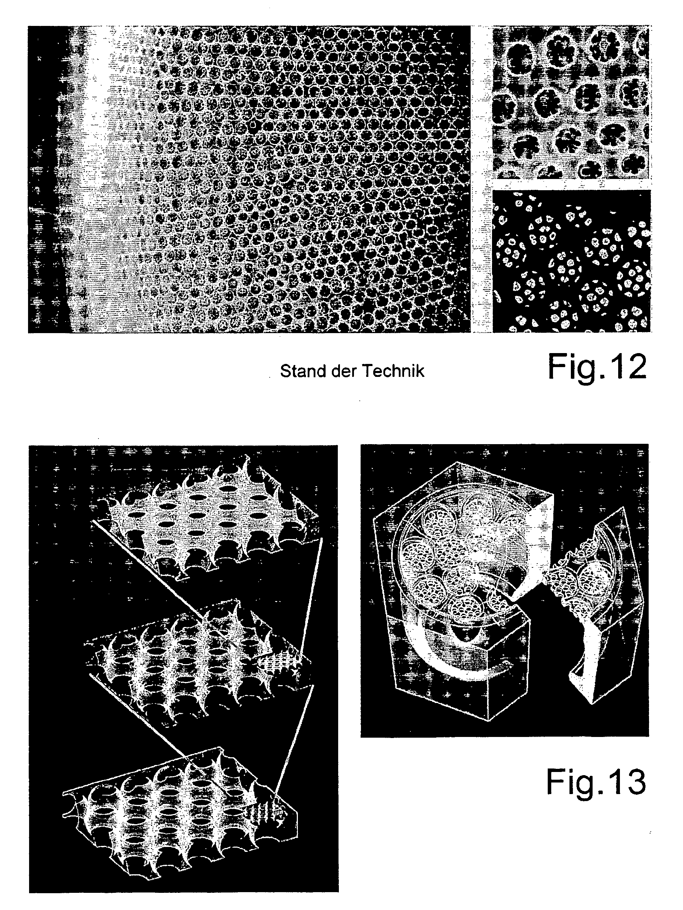

Aus den Organismen mit biologischen Leichtbauschalen (insbesondere planktonische, biomineralisierte Einzeller) wurde die Gruppe der *Diatomeen,* speziell solcher mit so genannten "loculaten Areolen" (wabenartigen Schalenstrukturen mit oft fraktalem Porenaufbau) ausgewählt. In der **Figur 12** sind Raster- und Transmissionselektronenmikroskopische Darstellungen der fraktal aufgebauten Poren von *Coscinodiscus wailesii* mit Porengrößen von 800 nm, 15 nm und 30 nm dargestellt. Die Schalen von Kieselalgen müssen aufgrund des spezifischen Selektionsdruckes genau diese Anforderungen an Stabilität und geringem Gewicht sowie Permeabilität erfüllen, wobei statt des Wärmeaustausches der Austausch von Nährstoffen und Stoffwechselprodukten im Vordergrund steht, der aber denselben Prinzipien folgt. Dabei sind die kleinsten Poren von der Schalenaußenseite auch mit dem Rasterelektronenmikroskop oft nicht zu erkennen, also extrem klein, ohne dass sich der Diffusionswiderstand stark erhöhen darf.

Als besonders geeignete Geometrien wurden die von Arten wie *Coscinodiscus* identifiziert, da diese Schalen mit sehr kleinen, regelmäßigen und in der Größe wenig variablen Poren besitzen. Der Einsatz einer nach biologischem Vorbild hierarchisch gegliederten Porenstruktur auf der Gesamtoberfläche eines Computergehäuses (bei Bedarf inklusive der Tastatur) kann dabei einen effektiven Wärmeaustausch gewährleisten. Die aus produktionstechnischer Sicht aufgestellten Kriterien - der Einsatz bereits entwickelter Produktionsverfahren - können durch eine Kombination aus Hohlkörpern unterschiedlicher Größe erfüllt werden.

Mikromechanische Tests ("Nadeltest", vergleiche weiter oben) wurden an zentrischen Diatomeen (*Coscinodiscus* und *Thalassiosira*) durchgeführt. Durch diese Tests konnten generell günstige mechanische Eigenschaften der Schalen nachgewiesen werden, insbesondere lieferten die Versuche Hinweise auf ein hohes Maß an Steifigkeit. Da diese Eigenschaften mit durch den spezifischen Aufbau im µm-Bereich hervorgerufen wird, ist es möglich, die Bauprinzipien auf technische Schalen aus anderen Werkstoffen zu übertragen.

### 3. Auswahl von Feinstrukturen der aussichtsreichsten Bereiche der vorausgewählten Schalenarchitekturen

Aus der Gesamtstruktur der *Diatomeen* wurden ausschließlich die Poren genauer analysiert, nicht dagegen deren Anordnung, die durch die kreisförmige Gesamtoberfläche der Valve gegeben ist. Ebenfalls wurden die Randbereiche und diverse Fortsätze (Rimoportulae, Fultoportulae) der Schale nicht in die Auswahl einbezogen.

### 4. Direkte Abnahme der konstruktiven Daten von den ausgewählten Feinstrukturen

Die Daten wurden aus licht- und rasterelektronenmikroskopischen Aufnahmen gewonnen und mit Hilfe von CAD- und FE- Programmen in 3D- Modelle (idealisierte Standardpore) transferiert. Ausgehend von diesem 3D- Modell werden verschiedene Varianten entwickelt und mit Hilfe von FE-Analysen auf verschiedene physikalische Charakteristika getestet.

### 5. Skalierung der abgenommenen Daten auf die Grundparameter der permeablen Leichtbauschale

Die Skalierung erfolgt im Wesentlichen auf der Basis der Originalvorlage, was durch die spezifischen Ähnlichkeitsgesetze für Schalen ermöglicht wird.

### 6. Aufbereitung der skalierten Daten zu einem Satz von Erstmodelldaten der permeablen Leichtbauschale

Die Aufbereitung orientiert sich and den produktionstechnischen Möglichkeiten zur Erzeugung von Prototypen und ggf. einem serientauglichen Produktionsverfahren. In der Figur 13 ist links ein fraktales Schichtenmodell für eine realisierbare Struktur dargestellt, das in erster Näherung drei Schichten offene Hohlkugeln in einer Matrix zeigt. Die maximalen Hohlraumdurchmesser stehen in einem Verhältnis 125:5:1, z.B. 1cm, 2 mm und 400µm. In der Figur 13 rechts ist ein Ausschnitt einer kleinsten Pore im Modell dargestellt. Zu erkennen sind der unten geöffnete Hohlkörper und die oben eingelagerten kleineren Hohlkörper mit Membranfunktion.

### 7. Optimierung des Erstmodells

Gegenwärtig werden insbesondere Statik und Permeabilität der Struktur mit Hilfe Von FE- Berechnungen untersucht, um eventuell durch Modifikationen die geforderten Leistungsmerkmale noch zu optimieren.

### Bezugszeichenliste

- **AB**: Abrundung
- **BO**: Bohrung
- **EM**: Erstmodell
- **FB**: Felgenbett
- **FK**: Felgenkörper
- **KP**: Kreisplatte
- **RAS**: Radialspeiche
- **RIS**: Ringspeiche
- **SA**: Speichenaufbau
- **ZB**: zentrale Bohrung

## Patentansprüche

1. Rechnergestütztes Verfahren zur Ermittlung von konstruktiven Erstmodelldaten für eine technische Leichtbaustruktur mit den Verfahrensschritten :
1. Bereitstellung der relevanten Grundparameter der zu erstellenden technischen Leichtbaustruktur in Bezug auf die technische Problemstellung,
2. Vorauswahl von einem oder mehreren biomineralisierten Einzellern mit zu den bereitgestellten Grundparametern passenden natürlichen Schalenarchitekturen,
3. Auswahl von einer oder mehreren Feinstrukturen der für eine technische Realisierung aussichtsreichsten Bereiche der vorausgewählten Schalenarchitekturen,
4. direkte Abnahme der konstruktiven Daten von den ausgewählten Feinstrukturen,
5. Skalierung der abgenommenen konstruktiven Daten auf die Grundparameter der zu erstellenden technischen Leichtbaustruktur,
6. Kombination und Anpassung der skalierten konstruktiven Daten zu einem Satz von Erstmodelldaten für ein Erstmodell der zu erstellenden technischen Leichtbaustruktur und
7. Optimierung des Erstmodells.

2. Rechnergestütztes Verfahren nach Anspruch 1 mit einer Ablage gemeinsamer beschreibender Eigenschaften technischer Leichbaustrukturen und Schalenarchitekturen biomineralisierter Einzeller als organisierte Sammlung von Aspekten und Aspektwerten in einer Datenbank.

3. Rechnergestütztes Verfahren nach Anspruch 1 oder 2 mit einer Ablage einer durch ihre bekannten Eigenschaften charakterisierten Hierarchie einzelner Strukturelemente, größerer Unterstrukturen und ganzer Schalenarchitekturen biomineralisierter Einzellern als organisierte Sammlung in einer Datenbank.

4. Rechnergestütztes Verfahren nach einem der Ansprüche 1 bis 3 mit einer direkten Abnahme der konstruktiven Daten von den ausgewählten Feinstrukturen oder Unterstrukturen durch zumindest halbautomatisches mikroskopisches Scannen.

5. Rechnergestütztes Verfahren nach einem der Ansprüche 1 bis 4 mit einer Ablage der direkt abgenommenen konstruktiven Daten als organisierte Sammlung in einer Datenbank.

6. Rechnergestütztes Verfahren nach einem der Ansprüche 1 bis 5 mit einer Ablage von Kriterien für die Skalierung, die Kombination und die Anpassung der konstruktiven Daten, von Erstmodellen und deren Optimierungsergebnissen als organisierte Sammlung in einer Datenbank.

7. Rechnergestütztes Verfahren nach einem der Ansprüche 1 bis 6 mit einer Vorauswahl von *Arachnoidiscus oder Coscinodiscus* aus der Gruppe der *Diatomeen* als biomineralisierter Einzeller.

8. Rechnergestütztes Verfahren nach einem der Ansprüche 1 bis 6 mit einer Vorauswahl von *Phaeodarien* aus der Gruppe der Radiolarien als biomineralisierte Einzeller.

## Claims

1. A computer-assisted method for determining constructional prototype data for a technical lightweight structure with the method-related steps of:
1. providing the relevant basic parameters of the technical lightweight structure to be created with regard to the technical problem,
2. preselecting one or several biomineralised unicellular organisms with natural shell architectures that are suitable for the basic parameters provided,
3. selecting one or several fine structures of the regions of the preselected shell architectures that are most promising in terms of technical implementation,
4. directly taking the constructional data from the selected fine structures,
5. scaling the taken constructional data onto the basic parameters of the technical lightweight structure to be created,
6. combining and adapting the scaled constructional data to form a set of prototype data for a first model of the technical lightweight structure to be created, and
7. optimising the prototype.

2. The computer-assisted method according to claim 1 with the filing of shared describing characteristics of technical lightweight structures and shell architectures of bio-mineralised unicellular organisms as an organised collection of aspects and aspect values in a database.

3. The computer-assisted method according to claim 1 or 2 with the filing of a hierarchy of individual structural elements, which hierarchy is **characterised by** its known characteristics, of major substructures and entire shell architectures of biomineralised unicellular organisms as an organised collection in a database,.

4. The computer-assisted method according to any one of claims 1 to 3 with the direct taking of the constructional data from the fine structures or substructures selected, by means of at least semiautomatic microscopic scanning.

5. The computer-assisted method according to any one of claims 1 to 4 with the filing of the directly taken constructional data as an organised collection in a database.

6. The computer-assisted method according to any one of claims 1 to 5 with the filing of criteria for scaling, combining and adapting the constructional data, of prototypes and their optimisation results as an organised collection in a database.

7. The computer-assisted method according to any one of claims 1 to 6 with the preselection of *Arachnoidiscus* or *Coscinodiscus* from the group of diatoms as biomineralised unicellular organisms.

8. The computer-assisted method according to any one of claims 1 to 6 with the preselection of *Phaeodaria* from the group of *Radiolaria* as biomineralised unicellular organisms.

## Revendications

1. Procédé assisté par ordinateur de détermination de données de construction de modèle initial pour une structure de construction légère comprenant les étapes de :
1. fourniture des paramètres de base pertinents de la structure de construction légère a concevoir en rapport avec les données techniques du problème,
2. présélection d'un ou plusieurs organisme(s) unicellulaire(s) biominéralisé(s) comprenant des architectures d'enveloppe naturelles convenant aux paramètres de base fournis,
3. sélection d'une ou plusieurs structure(s) fine(s) des zones des architectures d'enveloppe présélectionnées présentant le plus de perspectives pour une réalisation technique,
4. réception directe des données de construction des structures fines sélectionnées,
5. mise à l'échelle des données de construction reçues aux paramètres de base de la structure de construction légère a concevoir,
6. combinaison et adaptation des données de construction mises à l'échelle à un jeu de données de modèle initial pour un modèle initial de la structure de construction légère a concevoir et
7. d'optimisation du modèle initial.

2. Procédé assisté par ordinateur selon la revendication 1, comprenant un archivage de propriétés descriptives communes de structures de construction légère et d'architectures d'enveloppe d'organismes unicellulaires biominéralisés en tant que recueil organisé d'aspects et de valeurs d'aspect dans une base de données.

3. Procédé assisté par ordinateur selon la revendication 1 ou 2, comprenant un archivage d'une hiérarchie **caractérisée par** ses propriétés connues, de différents éléments structurels, de sous-structures plus grandes et d'architectures d'enveloppe complètes d'organismes unicellulaires biominéralisés en tant que recueil organisé dans une base de données.

4. Procédé assisté par ordinateur selon l'une des revendications 1 à 3 comprenant une réception directe de données de construction des structures fines ou sous-structures sélectionnées par au moins un balayage microscopique semi-automatisé.

5. Procédé assisté par ordinateur selon l'une des revendications 1 à 4 comprenant un archivage des données de construction reçues directement en tant que recueil organisé dans une base de données.

6. Procédé assisté par ordinateur selon l'une des revendications 1 à 5 comprenant un archivage de critères pour la mise à l'échelle, la combinaison et l'adaptation des données de construction, de modèles initiaux et de leurs résultats d'optimisation en tant que recueil organisé dans une base de données.

7. Procédé assisté par ordinateur selon l'une des revendications 1 à 6 comprenant une présélection *d'arachnoidiscus* ou de *coscinodiscus* du groupe des *diatomées* en tant qu'organismes unicellulaires biominéralisés.

8. Procédé assisté par ordinateur selon l'une des revendications 1 à 6 comprenant une présélection de *phaeodariés* du groupe des *radiolaires* en tant qu'organismes unicellulaires biominéralisés.
